(19) **Europäisches Patentamt** / **European Patent Office** / **Office européen des brevets**

(11) **EP 1 883 975 B1**

(12) **FASCICULE DE BREVET EUROPEEN**

(45) Date de publication et mention de la délivrance du brevet:
**19.12.2012 Bulletin 2012/51**

(51) Int Cl.:
*H01L 31/032* *(2006.01)*    *H01L 31/18* *(2006.01)*
*H01L 31/0749* *(2012.01)*

(21) Numéro de dépôt: **06755519.3**

(22) Date de dépôt: **19.05.2006**

(86) Numéro de dépôt international:
**PCT/FR2006/001149**

(87) Numéro de publication internationale:
**WO 2006/125898 (30.11.2006 Gazette 2006/48)**

(54) **SULFURISATION ET SELENISATION DE COUCHES DE CIGS ELECTRODEPOSE PAR RECUIT THERMIQUE**

SULFURISIERUNG UND SELENISIERUNG VON ELEKTROLYTISCH DURCH THERMISCHES AUSHEIZEN ABGELAGERTEN CIGS-SCHICHTEN

SULPHURISATION AND SELENISATION OF CIGS LAYERS ELECTROLYTICALLY DEPOSITED BY THERMAL ANNEALING

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **25.05.2005 FR 0505277**

(43) Date de publication de la demande:
**06.02.2008 Bulletin 2008/06**

(73) Titulaires:
• **CENTRE NATIONAL DE LA RECHERCHE SCIENTIFIQUE (CNRS)**
**75794 Paris Cedex 16 (FR)**
• **Electricité de France**
**75008 Paris (FR)**

(72) Inventeurs:
• **TAUNIER, STÈPHANE**
**San Diego, CA 92109 (US)**
• **LINCOT, Daniel**
**F-92160 Antony (FR)**
• **GUILLEMOLES, Jean-François**
**F-75013 Paris (FR)**
• **NAGHAVI, Negar**
**F-75017 Paris (FR)**
• **GUIMARD, Denis**
**F-75013 Paris (FR)**

(74) Mandataire: **Cabinet Plasseraud**
**52, rue de la Victoire**
**75440 Paris Cedex 09 (FR)**

(56) Documents cités:
**WO-A-03/094246**    **WO-A1-01/37324**
**FR-A- 2 849 450**    **FR-A- 2 849 532**
**US-A- 5 578 503**

• **NADENAU V ET AL: "SOLAR CELLS BASED ON CUINSE2 AND RELATED COMPOUNDS: MATERIAL AND DEVICE PROPERTIES AND PROCESSING" PROGRESS IN PHOTOVOLTAICS. RESEARCH AND APPLICATIONS, JOHN WILEY AND SONS, CHICHESTER, GB, vol. 3, no. 6, 1 novembre 1995 (1995-11-01), pages 363-382, XP000545817 ISSN: 1062-7995**

**Description**

La présente invention concerne le domaine des dépôts de couches minces de semi-conducteurs pour des applications photovoltaïques.

Des couches minces de diséléniure et/ou disulfure de cuivre et d'indium et/ou de gallium (appelé CIGS ou CIS) sont déposées sur substrat pour fabriquer des cellules photovoltaïques. De tels composés, de formule générale $CuGa_xIn_{1-x}Se_{2-y}S_y$ (avec x compris entre 0 et 1 et y compris entre 0 et 2), notée CIGSSe, sont considérés comme très prometteurs et pourraient constituer la prochaine génération de cellules solaires en couches minces. Les matériaux semi-conducteurs CIGSSe ont une largeur de bande interdite ("gap direct) qui peut être fixée entre 1,0 et 2,5 eV, ce qui permet une absorption optimale des radiations solaires dans le domaine du rayonnement solaire. Des rendements de conversion records, de 19,5%, ont été obtenus récemment sur des cellules de petites surfaces. Les composés CIGSSe sont aussi dénommés $I-III-VI_2$, en référence à la nature chimique de leurs constituants, où :

- l'élément Cu représente un élément de la colonne I (colonne 1 B de la table de classification de Mendeleïev),
- l'élément In et/ou l'élément Ga représentent des éléments de la colonne III (colonne 3B de la table de classification de Mendeleïev), et
- l'élément Se et/ou l'élément S représentent un élément de la colonne VI (colonne 6B de la table de classification de Mendeleïev).

On compte donc approximativement deux atomes de la colonne VI pour un atome de la colonne I et un atome de la colonne III, dans le domaine monophasé autour de la composition $I-III-VI_2$ du CIGS.

Les couches de CIGS utilisées pour la conversion photovoltaïque doivent présenter un caractère semi-conducteur de type p et de bonnes propriétés de transport de charge. Ces propriétés de transport de charge sont favorisées par une bonne cristallinité. Ainsi, les composés CIGS doivent être au moins partiellement cristallisés pour posséder des propriétés photovoltaïques suffisantes pour leur application à la fabrication de cellules solaires. Les composés CIGS cristallisés ont une structure cristallographique correspondant au système des chalcopyrites ou des sphalérites, suivant la température de dépôt. Un procédé de fabrication de tels semi-conducteurs est connu de la demande WO03/094246.

Les matériaux chalcopyrites comme par exemple de type $Cu(In,Ga)(S,Se)_2$ ont des largeurs de bande interdite variant entre 1,0 eV pour $CuInSe_2$ et 2,4 eV pour $CuGaS_2$. Les cellules solaires présentent les meilleurs rendements et les modules commercialisés sont préparés à partir d'absorbeurs avec des rapports Ga/(Ga+In) compris entre 25 et 30 %, correspondant à des bandes interdites de 1,12 eV. L'utilisation de cellules solaires basées sur des absorbeurs à plus grande bande interdite revêt deux intérêts : d'une part, elles sont proches de la valeur optimale de 1,5 eV d'absorption du spectre solaire. D'autre part, pour une application module, les pertes dues aux résistances séries sont réduites pour de grandes tensions et de faibles courants.

A partir d'absorbeurs de $CuInSe_2$, il est possible d'augmenter la valeur de la bande interdite en substituant des atomes d'indium et/ou de sélénium par des atomes de gallium et/ou soufre, respectivement. Les cellules record actuelles, présentant des rendements de 18%, sont obtenues en substituant environ 30 % des atomes d'indium par des atomes de gallium.

Il est également possible d'augmenter la bande interdite du $CuInSe_2$ en remplaçant une partie des atomes de sélénium par des atomes de soufre. On notera ce procédé par la suite « procédé de sulfuration » de $CuInSe_2$.

La sulfuration de précurseurs métalliques ou binaires a été décrite. Dans V. Alberts, F. D. Dejene, Journal of Physics D : Appl. Phys. 35 (2002) 2021-2025 par exemple, la sulfuration intervient sous pression de soufre élémentaire à des températures élevées, inférieures au point de ramollissement du verre (600°C). Dans K. Siemer, J. Klaer, I. Luck, J. Bruns, R. Klenk, D. Braünig, Solar Energy Materials and Solar Cells, 67 (2001) 159-166, un procédé par RTP (Rapid Thermal Process) permet le recuit des précurseurs métalliques de Cu-In à 600°C pendant trois minutes (temps total du recuit) et à des gradients de montée de l'ordre de $10°C.s^{-1}$. Le substrat est placé dans une enceinte en quartz et le soufre élémentaire est placé à côté du substrat. La chambre est mise sous vide avant recuit. La pression pendant le recuit est alors la pression saturante de soufre.

D'autres méthodes de sulfuration existent pour obtenir des couches minces de semi-conducteurs présentant des bandes interdites optimales, comme par exemple celle décrite dans le document US 5,730,852. Une couche de précurseur de composition $Cu_xIn_yGa_zSe_n$ (avec x, y, et z compris entre 0 et 2, et n compris entre 0, et 3), en utilisant une méthode par des courants pulsés. Cette étape est suivie par d'une étape de dépôt par évaporation sous vide d'une couche d'éléments Cu+Se ou In+Se. Un recuit final permet d'améliorer l'homogénéité et la qualité de la couche résultante.

Cependant ces méthodes font soit appel à des produits toxiques impliquant des contraintes fortes sur les procédés (utilisation d'atmosphère en $H_2S$ ou $H_2Se$), soit ne permettent pas de contrôler finement la largeur de bande interdite. Elles nécessitent également une étape de vide.

Par ailleurs, lorsqu'on utilise un élément VI sous sa forme solide (soufre ou sélénium sous forme de poudre par exemple à proximité du précurseur CIGS), des problèmes d'hétérogénéités de cet élément peuvent se poser.

Les documents US 5 578 503, WO 03/094246 A1, WO 01/37324 A1, FR 2 849 450 A1, FR 2 849 532 A1 et l'article "Solar cells based on CuInSe2 and related compounds: material and device properties and processing" par Nadenau et al., paru dans Progress in Photovoltaics : Research and applications, vol. 3, no. 6, 1995, pages 363-382, XP000545817, décrivent des procédés de fabrication de couches I-III-VI$_2$ à partir de couches précurseurs.

La présente invention permet de remédier aux inconvénients des techniques de sulfuration connues.

Elle propose à cet effet un procédé de fabrication en couches minces d'alliages semi-conducteurs de type I-III-VI$_2$ incluant du soufre, pour des applications photovoltaïques selon la revendication 1.

La diffusion du soufre dans la couche mince de CIGS permet ainsi d'obtenir une valeur désirée de la largeur de bande interdite, en particulier en jouant sur l'épaisseur de la couche incluant du soufre.

On entend par le terme « sensiblement amorphe » à l'étape a) le fait que la couche de précurseur CIGS se présente morphologiquement par des nanocristaux joints par une phase amorphe. Après l'étape de recuit, ces nanocristaux grossissent en taille et peuvent atteindre des tailles de l'ordre du micromètre.

Dans une réalisation préférée, le recuit effectué est dit « rapide ». Typiquement, il peut s'agir d'un recuit à lampes avec une forte puissance transmise aux couches pendant un faible laps de temps (inférieur à quelques dizaines de secondes).

La couche mince contenant au moins du soufre, ainsi que d'éventuelles couches supplémentaires de sélénium sont déposées par dépôt chimique en solution (Chemical Bath Deposition, ou CBD).

Ainsi, la présente invention permet de résoudre les problèmes posés par les méthodes connues de sulfuration ou sélénisation. Il n'y a donc pas d'utilisation d'atmosphère d'H$_2$S ou H$_2$Se, ni d'utilisation de soufre ou de sélénium disposé à proximité du substrat sous forme de poudre.

D'autres caractéristiques et avantages de l'invention apparaîtront encore à la lecture de la description qui va suivre. Celle-ci est purement illustrative et doit être lue en regard des dessins annexés sur lesquels :

- la figure 1 est une vue en coupe d'une couche mince de CIGS sur laquelle a été déposée une couche contenant au moins du soufre à partir du procédé selon l'invention,
- la figure 2 représente schématiquement une installation de dépôt, par électrochimie, d'une couche mince de CIGS,
- la figure 3 représente schématiquement l'aspect de la structure sous forme de matrice d'un précurseur avant recuit, à l'échelle nanométrique,
- la figure 4 représente une installation de recuit rapide, par éclairage de la couche mince obtenue par électrodéposition,
- la figure 5 représente schématiquement la structure, en couches minces, d'une cellule destinée à des applications photovoltaïques,
- la figure 6.1 illustre à titre d'exemple un profil temporel d'une densité de puissance transférée à la couche, pendant une impulsion lumineuse;
- la figure 6.2 illustre, à titre d'exemple pour du CIGS, des couples de durées (abscisses) et de densités moyennes de puissance d'éclairement (ordonnées) permettant de cristalliser au moins partiellement une couche sans la dégrader,
- la figure 7 illustre l'épaisseur de soufre déposé par dépôt chimique en solution, mesurée par fluorescence X (XRF), en fonction du temps de dépôt et du taux d'acidification des solutions de thiosulfates,
- la figure 8 illustre la variation du taux de sulfuration des films après recuit, en fonction des épaisseurs de soufre déposées,
- la figure 9 illustre un exemple de dépôt de soufre sur un substrat verre/Mo/CIGS 30x30 cm$^2$ dans un réacteur horizontal, et ;
- la figure 10.1 illustre les épaisseurs de soufre effectives mesurées par fluorescence X dans le cas d'un substrat verre/Mo/CIGS 30x30 cm$^2$.
- la figure 10.2 illustre la variation du taux de sulfuration des films après recuit, en fonction des épaisseurs de soufre déposées, dans le cas d'un substrat verre/Mo/CIGS 30x30 cm$^2$.

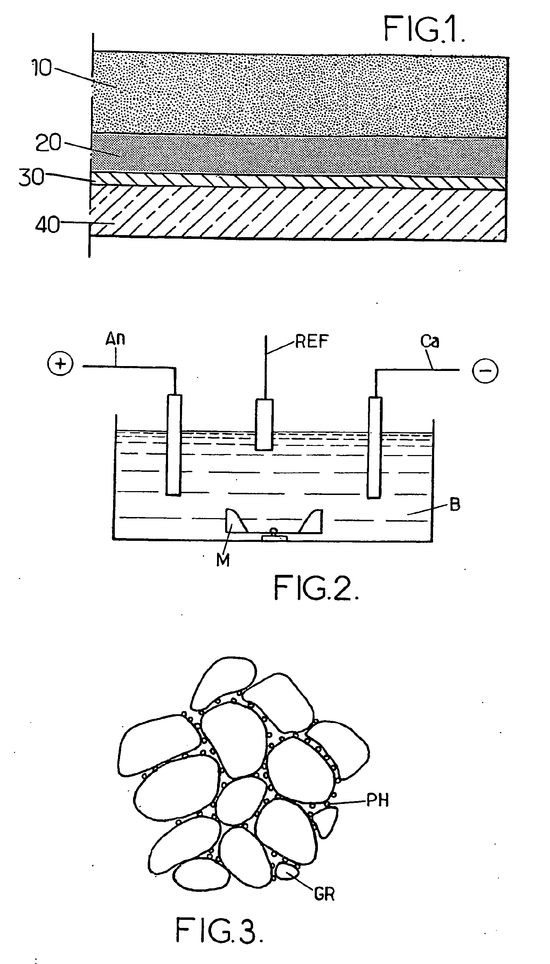

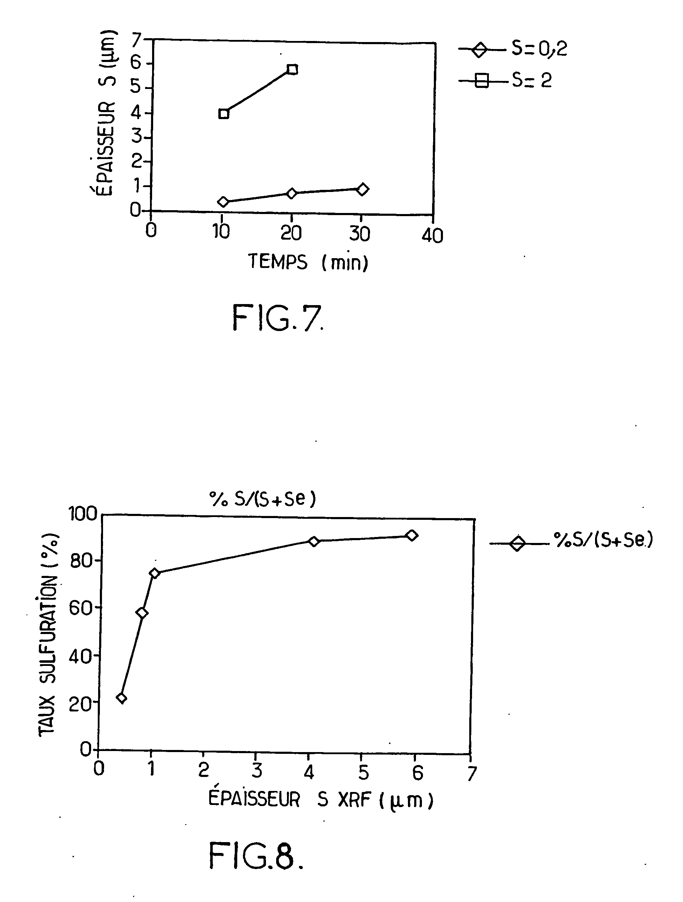

L'étape a) du procédé de fabrication selon l'invention comprend le dépôt d'une hétérostructure comprenant une couche mince de précurseur I-III-VI$_2$ sensiblement amorphe, et correspondant aux Figures 1 à 3, et une couche mince incluant au moins du soufre, illustrée à la Figure 7. Le dépôt de la couche mince de précurseur sera décrit dans un premier temps.

La figure 1 est une vue en coupe d'une couche mince de CIGS sur laquelle a été déposée une couche contenant au moins du soufre à partir du procédé selon l'invention. La couche de soufre 10 est déposée sur la surface du précurseur CIGS 20. Ce dernier a été déposé par électrolyse sur un substrat par exemple du verre 40, revêtu d'une couche conductrice, par exemple du molybdène 30, pour favoriser l'électrolyse et le dépôt du précurseur CIGS 20.

Le dépôt de la couche de précurseur peut être réalisé par les techniques connues de l'homme du métier. Un dépôt par sérigraphie du précurseur CIGS peut être par exemple envisagé. La couche peut aussi être déposée selon le procédé décrit dans la demande WO03/094246, comme repris ci-dessous.

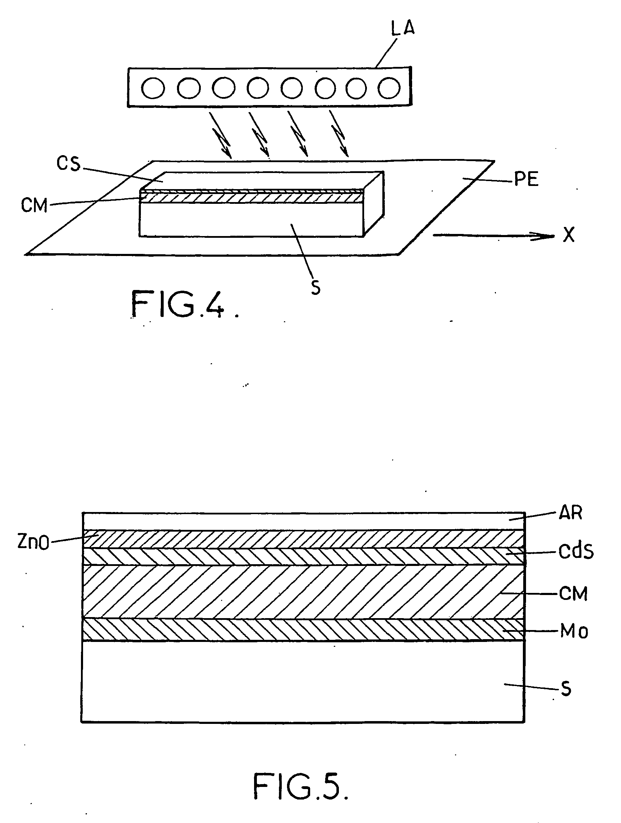

Des couches minces (ou "films") de précurseur CIGS sont obtenues à pression et température ambiante par électrodéposition d'un film CM sur un substrat de verre S, recouvert de molybdène Mo au préalable (figure 5). Avantageusement, le substrat S est initialement recouvert d'une couche supplémentaire, conductrice, électronique, par exemple métallique ou sous forme d'oxyde (non représentée). Cette couche conductrice peut en outre reposer sur une ou plusieurs sous-couches servant à une application spécifique (barrière de diffusion, miroir ou autre) dans la fabrication de cellules photovoltaïques.

En se référant à la figure 2, l'électrodéposition est effectuée dans un bain B contenant un sel d'indium, un sel de cuivre et de l'oxyde de sélénium dissous. Pour l'obtention d'une couche mince de CIGS, dont la composition générale correspond sensiblement à $CuGa_xIn_{1-x}Se_2$ (avec x compris entre 0 et I), on comprendra que le bain peut contenir en outre un sel de gallium. Dans une variante encore plus sophistiquée, des sels de soufre (par exemple de sulfite ou de thiosulfate) peuvent être ajoutés à la solution de manière à obtenir un dépôt de composition voisine de $CuGa_xIn_{1-x}Se_{2y}S_y$ (avec x compris entre 0 et 1 et y compris entre 0 et 2). Les sels sont mélangés pendant le dépôt grâce à un agitateur tournant M (ou à peigne) immergé dans le bac d'électrochimie B. La configuration de la figure 2 montre une agitation du bain par barreau magnétique. Pour des applications grandes surfaces on peut remplacer avantageusement ce système par un agitateur à barreaux oscillants (dit à peigne).

Ainsi, la couche mince est obtenue par électrodéposition d'un précurseur dont les éléments constitutifs sont intimement pré-mélangés. Les concentrations des éléments du précurseur (sous forme de sels et d'oxydes dans la solution) sont comprises entre $10^{-4}$ et $10^{-1}$ mol/L. Préférentiellement, le pH de la solution est fixé entre 1 et 4. Le potentiel appliqué à l'électrode de molybdène (cathode Ca) est compris entre -0,8V et -1,9V par rapport à l'électrode de référence REF, ici au sulfate mercureux (- 0,65 V vs l'électrode normale à hydrogène).

Des dépôts de couches minces d'épaisseur comprise entre 0,1 et 3 $\mu$m sont obtenus, avec des densités de courant d'environ 0,5 à 4 mA/cm$^2$.

A titre d'exemple non limitatif, un dépôt de précurseur est réalisé à partir d'un bain dont les concentrations sont les suivantes: $[Cu(SO_4)]$ = 1,0.10$^{-3}$ mol/l, $[In_2(SO_4)_3]$ = 6,0.10$^{-3}$ mol/l, $[H_2SeO_3]$ = 1,7.10$^{-3}$ mol/l, $[Na_2(SO_4)]$ = 0,1 mol/l. Le pH du bain est de 2 dans cet exemple. Les précurseurs sont déposés par réaction cathodique à potentiel imposé, de préférence -1V par rapport à l'électrode de référence au sulfate mercureux. La densité de courant est de -1 mA/cm$^2$.

Dans la mesure où les sels de cuivre et d'indium et/ou de gallium, ainsi que l'oxyde de sélénium dissous, sont mélangés dans la solution du bain B, à la fin de l'étape précitée d'électrodéposition, on obtient un précurseur dont les éléments sont intimement pré-mélangés. Le film de précurseur obtenu est dense, adhérent, de morphologie homogène et sa composition est proche d'une composition stoechiométrique Cu (25%), In+Ga (25%), Se (50%).

En se référant à la figure 3, les films obtenus après l'étape d'électrodéposition sont constitués d'une matrice globalement amorphe (ou peu cristallisée par rapport à l'alliage après recuit) mais comprenant majoritairement des grains GR de CIGS (cristallites de l'ordre de quelques dizaines de nanomètres).

On entend par "grains nanométriques", des grains d'alliages qui, avantageusement, présentent majoritairement une nature physico-chimique proche de celle de l'alliage visé après recuit et pouvant atteindre jusqu'à quelques dizaines de nanomètres.

L'ensemble des grains au sein de la couche forme alors une matrice avantageusement compacte et capable de supporter une augmentation brusque en température pendant l'étape de recuit.

On entend par le terme "matrice" une nature composite de la couche susceptible de présenter plusieurs phases PH possibles: ternaire (dans le cas du CIGS), binaire (par exemple $Cu_xSe$ avec x voisin de 2 et $In_xSe_y$ avec x voisin de 2 et y voisin de 3), ou même élémentaire (sélénium). Les grains GR sont de composition proche de celle désirée pour l'alliage final, par exemple $CuInSe_2$ dans le cas du CIGS. Le volume de la couche occupé par les grains GR reste néanmoins largement prépondérant par rapport à celui occupé par ces phases PH.

Les couches minces de CIGS, lorsqu'elles sont déposées à basse température (dépôt de précurseur), sont faiblement cristallisées voire proches de l'amorphe et un recuit des couches par apport thermique doit être réalisé pour obtenir une amélioration de la cristallisation du CIGS et des propriétés de transport de charge satisfaisantes. Ce recuit correspond à l'étape b) du procédé et sera décrit ultérieurement. On peut cependant prévoir un pré-recuit partiel supplémentaire entre l'étape a) et l'étape b) afin d'amorcer une cristallisation partielle de la couche mince de précurseur.

Dans une seconde phase de l'étape a) du procédé selon l'invention, une couche mince, contenant au moins du soufre, est déposée. Dans un mode de réalisation préféré, elle présente une interface commune avec la couche de précurseur CIGS. Dans un mode de réalisation supplémentaire, elle est déposée directement sur la couche de précurseur CIGS. Ce soufre, lors du recuit de l'étape b) va occuper des sites des cristaux de CIGS dans la couche mince de CIGS par diffusion, pour venir remplacer des atomes de sélénium.

La couche mince incluant du soufre est déposée par dépôt chimique en solution (Chemical Bath Deposition, ou CBD). Ce type de dépôt va être décrit ci-après.

Une solution contenant des ions thiosulfates $S_2O_3^{2-}$ est acidifiée afin de former du soufre élémentaire par dismutation du soufre initialement à l'état d'oxydation +II en soufre 0 et soufre +IV, selon la réaction ci-dessous :

$$S_2O_3^{2-} + H^+ \rightarrow HSO_3^- + S$$

Les précurseurs utilisés sont des précurseurs de Cu(In,Ga)Se$_2$ ou de CuInSe$_2$ déposés par électrodéposition sur des substrats de verre/molybdène comme décrit précédemment.

Une solution de thiosulfate de sodium Na$_2$S$_2$O$_3$ à 0,1 M est préparée et chauffée à 70°C sous agitation. D'autres sels peuvent être utilisés comme le sel de lithium, de potassium ou d'ammonium. Les substrats de verre/Mo/CIGS sont disposés horizontalement dans le réacteur (bécher ou cristallisoir). Le réacteur est disposé sur une plaque chauffante et la solution de thiosulfate de sodium est alors versée sur les précurseurs. Le volume de la solution utilisé dépend du nombre de substrats à traiter. La hauteur typique de solution au-dessus des substrats est de 1 cm.

A partir d'une solution concentrée (par exemple 10 M) est alors ajouté le volume d'une solution acide, par exemple de l'acide chlorhydrique, correspondant à un mélange de préférence équimolaire de protons H$^+$ et d'ions thiosulfate S$_2$O$_3^{2-}$. La solution devient trouble immédiatement. Il peut se former des colloïdes de soufre de couleur typique jaune. La solution est maintenue à une température entre 0 et 70°C, préférablement entre 40 et 70°C. Après un certain temps de dépôt, les substrats sont sortis de la solution, rincés à l'eau déionisée et séchés à l'argon ou à l'azote.

Des dépôts jaunes de soufre sont obtenus. Ces dépôts sont homogènes et couvrants. Les épaisseurs de soufre déposées sont typiquement de quelques micromètres. Elles dépendent du temps de dépôt (temps de trempage), de la concentration de la solution de thiosulfates et aussi du taux d'acidification des solutions de thiosulfate. La figure 7 représente l'épaisseur de soufre déposé par CBD, épaisseur mesurée par fluorescence X (XRF), en fonction du temps de dépôt et du taux d'acidification des solutions de thiosulfates (rapport entre la concentration de protons et d'ions thiosulfates dans la solution finale). Les durées de dépôts typiques peuvent varier entre 1 minute et 30 minutes, selon le degré de sulfuration (c'est-à-dire la proportion de soufre) après recuit recherché. Une couche superficielle contenant au moins du soufre est ainsi déposée sur la couche mince de précurseur CIGS. Contrairement aux techniques connues dans lesquels l'homogénéité de la pression de soufre pendant le recuit dépend de la position de la source de soufre en poudre ou du régime hydrodynamique du flux de H$_2$S dans l'enceinte, cette homogénéité ne dépend plus dans le cas du CBD que de l'homogénéité en température du substrat pendant le recuit.

L'épaisseur des dépôts est de plusieurs μm, pour les dépôts les plus épais, caractérisés par des temps de dépôt de 30 minutes. Par ailleurs, les dépôts de soufre sont préférentiellement composés de soufre uniquement. Ils peuvent contenir des espèces provenant du bain chimique (oxygène, sodium). Cependant leur quantité est typiquement inférieure au %.

Les substrats de verre/Mo/CIGS/S sont alors recuits par un procédé de recuit thermique. De tels procédés sont connus de l'homme du métier, comme par exemple dans la demande de brevet WO 03/094246 concernant un procédé de recuit thermique rapide, et repris ci-après.

Différents types de recuits thermiques peuvent être utilisés. Un recuit rapide thermique est utilisé dans un mode de réalisation avantageux du procédé selon l'invention, dont un exemple va être décrit ci-dessous.

Le traitement thermique peut être effectué à partir d'un recuit rapide de la couche mince du précurseur électrodéposée CM et de la couche mince contenant au moins du soufre CS. En se référant à la figure 4, les couches CM et CS, ainsi que le substrat S, sont disposés sur un porte-échantillon PE. Ce dernier est, de préférence, capable de se déplacer dans un plan horizontal (déplacement le long de l'axe X, tel que représenté sur la figure 4), relativement à une source de lumière LA. Cette source, dans l'exemple décrit, est une rampe de lampes halogènes à forte puissance de rayonnement, avantageusement dans une bande d'absorption optique des couches CM et CS. Ainsi, on entend, dans l'exemple décrit, par "recuit rapide" un éclairement des films CM et CS de manière à permettre la diffusion du soufre de la couche superficielle vers la couche mince électrodéposée de précurseur, et une cristallisation du précurseur, pendant des durées totales de l'ordre de la dizaine à quelques dizaines de secondes. Ce recuit rapide est effectué dans un four à lampe (figure 4) dans lequel la couche mince peut recevoir par incidence directe des puissances rayonnées de l'ordre de 5W/cm$^2$ et plus. En variante, on peut prévoir un recuit rapide par chauffage à induction à partir d'une boucle de courant.

Une interprétation actuelle de l'effet du recuit est la suivante. L'énergie transférée à la couche mince pendant le recuit rapide rend actifs les éléments VI (Se et S), qui présentent des températures basses de fusion, ce qui amorce une agglomération des grains GR comme par frittage. Les grains GR, nanométriques dans le précurseur, se joignent en formant de plus gros grains, de taille sensiblement micrométrique. A plus haute température (>500°C) les binaires du type cuivre sélénium, qui peuvent être également présents dans la couche de précurseur, peuvent eux mêmes fondre et contribuer également aux mécanismes de cristallisation. Les éléments VI en excès, ainsi que les binaires cuivre sélénium, jouent pendant le recuit rapide, un rôle important d'agent de recristallisation et de passivation des défauts.

Avantageusement, les recuits peuvent être effectués à pression atmosphérique sous pression de gaz neutre (par exemple argon ou azote). De cette façon la vitesse d'évaporation des éléments VI en excès est limitée laissant plus de temps à l'effet de recrystallisation. Dans l'exemple décrit, la puissance maximale par unité de surface que reçoit effectivement la couche mince est estimée à 25 W/cm$^2$, en tenant compte de la puissance nominale des lampes, de la dispersion de la lumière entre les lampes et la couche mince, des pertes par réflexion, et autres.

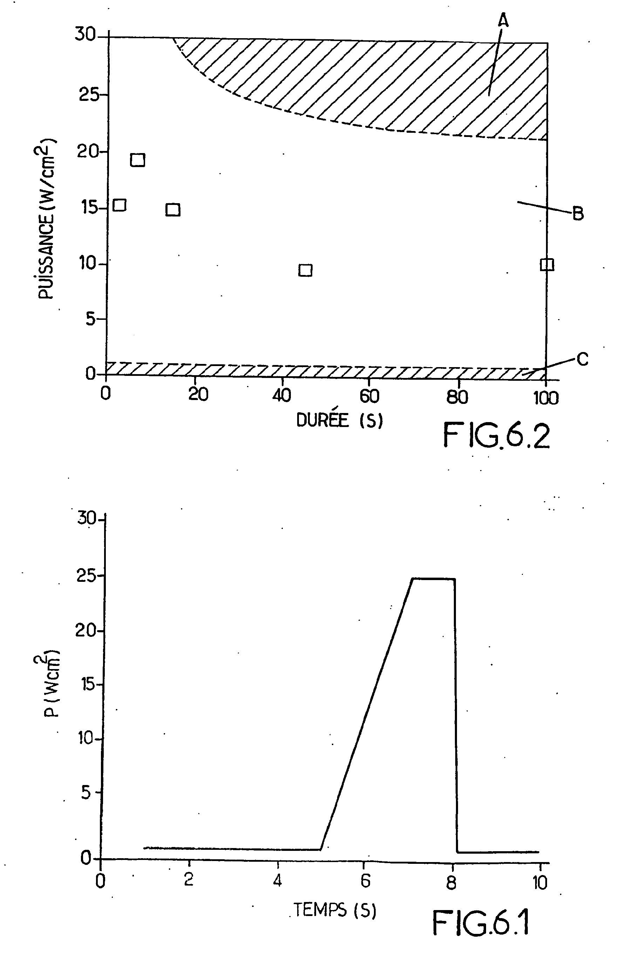

La figure 6.1 représente une impulsion à une puissance maximale, commandée pour 3 secondes. On constate cependant des fronts de montée et de descente de la puissance lumineuse délivrée en fonction du temps, dus à l'inertie des lampes. Néanmoins, l'expérience montre que de telles impulsions permettent déjà la diffusion du soufre et la cristallisation de la couche mince de CIGS de manière à obtenir de bonnes propriétés photovoltaïques.

La figure 6.2 représente des points expérimentaux (carrés foncés) correspondant à des couples puissance lumineuse moyenne/durée de recuit qui ont permis d'obtenir des couches cristallisées. L'impulsion précitée de 3 secondes correspond au premier point à gauche du graphique. Les zones A, B et C, délimitées par des courbes en traits pointillés, correspondent respectivement à:

- des couples puissance/durée pour lesquels la puissance est trop importante (zone A) et la couche est susceptible d'être dégradée pendant le recuit,
- des couples puissance/durée permettant d'obtenir une cristallisation satisfaisante de la couche (zone B), et
- des couples puissance/durée pour lesquels la puissance n'est pas suffisante pour recuire correctement la couche (zone C).

Typiquement, pour une épaisseur de couche voisine du $\mu$m déposée sur un substrat en verre, la puissance transférée à la couche est supérieure à quelques Watts par cm$^2$ (W/cm$^2$) pour commencer une cristallisation satisfaisante. Un recuit avantageux est obtenu pour une puissance transférée typiquement supérieure à 5 W/cm$^2$, et préférentiellement 10 W/cm$^2$, pendant une durée inférieure à 30 secondes. Un recuit avantageux est aussi obtenu pour une puissance supérieure à 15 W/cm$^2$, pendant une durée inférieure à quelques dizaines de secondes. Les puissances nécessaires d'une manière générale de l'ordre de quelques W/cm$^2$.

La couche mince CM, après recuit, est avantageusement recristallisée de façon sensiblement équivalente, voire meilleure, par rapport à ce qui est obtenu à l'issue des recuits classiques, à des températures supérieures à 450°C et pendant des durées voisines d'une heure.

Ainsi, selon l'un des avantages que procure la présente invention, la structure pré-mélangée du précurseur électrodéposé est de nature à favoriser le processus de recristallisation, cependant avec des durées bien inférieures à celles des recuits classiques.

Le recuit thermique rapide est typiquement effectué pendant des durées inférieures ou de l'ordre de quelques dizaines de secondes. Ces durées suffisamment courtes permettent sensiblement d'assurer la diffusion du soufre vers la couche de CIGS, ainsi que l'obtention de la composition désirée dans la couche mince d'alliage semi-conducteur, pour lui conférer ainsi des propriétés photovoltaïques, et notamment une largeur de bande interdite ajustée.

Lors du recuit, les atomes de soufre provenant de la couche de soufre déposée par dépôt chimique en solution remplacent les atomes de sélénium de la couche de CIGS. Le taux de substitution des atomes de sélénium par des atomes de soufre (ou taux de sulfuration) au sein de la couche de CIGS, y=S/(S+Se), dépend de la quantité de soufre disponible, et donc de l'épaisseur relative de la couche incluant au moins du soufre (et déposée par exemple par dépôt chimique en solution). La proportion de soufre dans l'alliage après recuit est donc contrôlée en fonction de l'épaisseur relative de la couche incluant du soufre (Figure 8). On entend par épaisseur relative de la couche incluant du soufre l'épaisseur de cette couche par rapport à l'épaisseur de la couche de précurseur CIGS.

Plus ce taux de substitution sera élevée, plus la bande interdite de l'absorbeur après recuit de formule approchée Cu(In$_x$,Ga$_{1-x}$)(S$_y$Se$_{1-y}$)$_2$, avec $0 \leq x \leq 1$ et $0 \leq y \leq 1$, sera élevée. La largeur de bande interdite est ajustée en fonction de la proportion de soufre, et par conséquent, en fonction de l'épaisseur de la couche 10.

Les films de précurseur après l'étape de dépôt ne possèdent que de faibles propriétés photovoltaïques en l'état. En fait, ces propriétés photovoltaïques sont obtenues seulement après un traitement par recuit thermique qui favorise également la diffusion du soufre vers le précurseur. La recristallisation de la couche mince permet d'obtenir de bonnes propriétés de transport et de type p pour la conversion photovoltaïque.

En contrôlant la quantité de soufre déposée par dépôt chimique en solution et donc disponible pour la sulfuration pendant le recuit, on peut alors contrôler la valeur de la bande interdite.

Après recuit thermique rapide, différents taux de sulfuration sont obtenus, selon l'épaisseur du dépôt de soufre par dépôt chimique en solution. Les taux de sulfuration varient de quelques pourcents (%) à 100% (Figure 8). On note que des taux de sulfuration élevés sont obtenus à la fois pour des absorbeurs riches en cuivre, mais également pour des absorbeurs riches en indium, présentant pourtant d'après préjugés classiques des coefficients de diffusion du soufre inférieurs.

Il apparaît ainsi possible, selon l'épaisseur de soufre déposée par CBD, c'est-à-dire selon l'épaisseur relative de la couche incluant du soufre, de contrôler le taux de sulfuration (proportion de soufre) des absorbeurs après recuit, et d'ajuster par conséquent la largeur de bande interdite. Selon le taux de sulfuration, les tensions de circuit ouvert varient entre 400 et 750 mV.

Table 1 :

| $y = \dfrac{S}{S + Se}$ | Eg (eV) | Icc (mA/cm$^2$) | Vco (mV) | FF (%) | Eff (%) |
|---|---|---|---|---|---|
| 10,0 % | 1,06 | 18,0 | 482 | 56,0 | 4,9 |
| 62,1 % | 1,29 | 20,7 | 621 | 60,4 | 7,8 |
| 86,4 % | 1,43 | 19,2 | 764 | 66,0 | 9,7 |

Paramètres I-V de cellules préparées par le procédé selon l'invention, avec différents taux de sulfuration après recuit sous éclairement simulé AM 1.5

avec :

- Eg le gap ou largeur de bande interdite, en eV
- Icc le courant de court circuit, en mA/cm$^2$
- Vco la tension de circuit ouvert, en mV
- FF, facteur de forme
- Eff, le rendement de conversion

Cette méthode de sulfuration peut être couplée à la méthode de sélenisation, présentée ci-après. On peut en effet réaliser des dépôts de S et de Se par dépôt chimique en solution. Ces structures de S/Se peuvent permettent peut-être d'optimiser la sulfuration des couches de CIGS en évitant une déplétion trop rapide des couches de CIGS en sélénium pendant les premières étapes de montée en température.

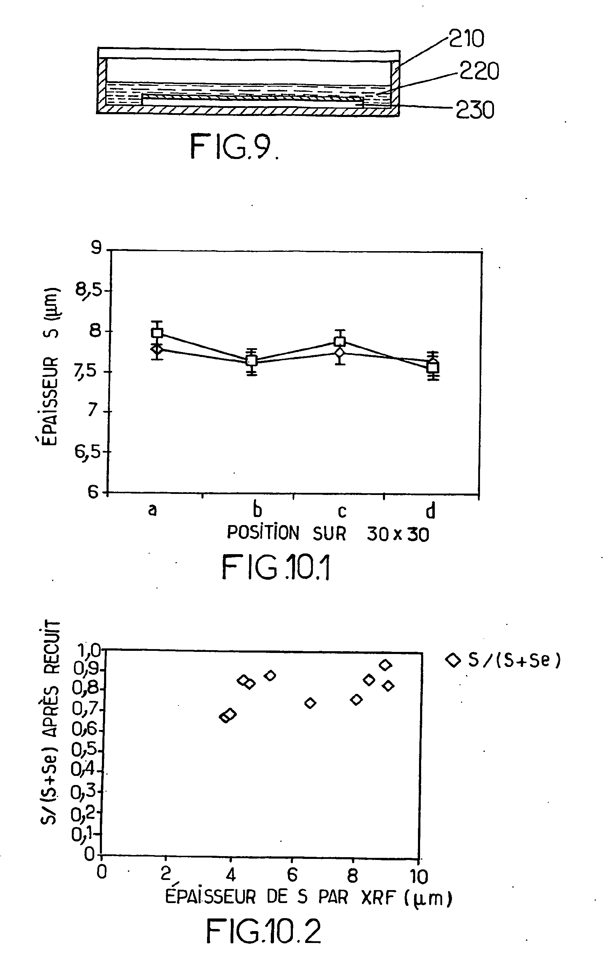

Un autre avantage important du procédé de fabrication selon l'invention est qu'il peut être facilement extrapolé aux grandes surfaces. En particulier, des dépôts de soufre par CBD ont été réalisés sur des substrats 30x30 cm$^2$ comme illustré sur la Figure 9. Un dépôt de soufre est réalisé sur des substrats verre/Mo/CIGS 230 d'une dimension 30x30 cm$^2$ dans un réacteur horizontal 210, la quantité de bain chimique 220 peut être minimisée.

L'épaisseur effective des films de soufre est mesurée par fluorescence X. Elle peut varier de quelques nanomètres à plusieurs micromètres suivant les conditions. Cependant, l'homogénéité du dépôt a été vérifiée sur 30x30 cm$^2$ comme illustrée à la Figure 10.1 pour une couche superficielle de soufre déposée par le procédé selon l'invention, et la dispersion des épaisseurs de cette couche est inférieure à 5% (comprise entre 7.5 et 8.0 $\mu$m sur le substrat 30x30 cm$^2$).

La Figure 10.2 illustre, sur ces mêmes substrats 30x30 cm$^2$, la corrélation qu'il peut exister entre l'épaisseur de soufre déposée par le procédé selon l'invention avant recuit et le taux de sulfuration des films après recuit. Dans la gamme explorée, le taux de sulfuration ne semble pas dépendre de l'épaisseur de soufre déposée par CBD : on est certainement au-delà de la saturation. Il faut noter toutefois que ce pallier de saturation dépend certainement des conditions expérimentales comme la composition du précurseur CIGS avant recuit, la forme du recuit, etc.

De la même façon, il est possible de déposer une couche de sélénium élémentaire par bain chimique ou CBD à la surface de précurseurs CIGS électrodéposés avec la couche superficielle de soufre. Il est en effet bien connu que la qualité de recristallisation des films de CIGS durant le recuit est très dépendante de la pression partielle en Se durant cette étape. L'atmosphère de Se est en principe générée par évaporation de Se élémentaire et/ou introduction de H$_2$Se. La couche superficielle déposée directement sur le précurseur, en plus de contenir au moins du soufre, contient dans ce cas également du sélénium.

La présente invention résout les mêmes problèmes que pour le soufre : hétérogénéités pour le Se solide et toxicité pour le séléniure d'hydrogène.

Le principe de l'invention est de dissoudre du Se élémentaire en milieu sulfite SO$_3$$^{2-}$ ou bisulfite S$_2$O$_5$$^{2-}$ pour former des complexes SeSO$_3$$^{2-}$ ou SeS$_2$O$_5$$^{2-}$ respectivement. La libération du Se est effectuée par acidification du milieu réactionnel qui provoque une précipitation contrôlée du Se élémentaire.

L'anion complexant semble jouer un rôle important. Les premières études ont montré que le dépôt de sélénium se réalisait plus facilement avec des ions disulfites S$_2$O$_5$$^{2-}$ plutôt qu'avec des ions sulfites SO$_3$$^{2-}$.

A la différence des complexes thiosulfate S$_2$O$_3$$^{2-}$, à partir desquels des dépôts de soufre se forment à la surface de films de CIGS, les complexes séléno-sulfate SeSO$_3$$^{2-}$ ne semblent pas donner de dépôts adhérents de sélénium, bien qu'il y ait précipitation de sélénium en solution après acidification. Cependant, les essais avec des complexes SeS$_2$O$_5$$^{2-}$ se sont avérés plus concluants.

Une solution de disulfite de sodium Na$_2$S$_2$O$_5$ à 0,1 M est préparée et chauffée à 40-90°C sous agitation. Cette préparation peut être effectuée éventuellement sous reflux pour des températures proches de 100°C. Le pH de la solution est porté à un pH basique, préférentiellement 10 par ajout d'un additif telle que la soude NaOH. Une faible quantité de sélénium élémentaire gris, préférentiellement inférieure ou égale à 0,05 mol/L, est ajoutée à la solution sous forme de poudre. La solution est agitée jusqu'à totale dissolution (environ 1 heure).

La solution préparée précédemment est alors versée sur les échantillons de CIGS dans un réacteur. Le volume de la solution utilisé dépend du nombre de substrats à traiter. Le dépôt chimique en solution de la couche mince supplémentaire riche en sélénium est effectué dans des plages de températures comprises entre 0°C et 80°C. La hauteur typique de solution au-dessus des substrats est de 1 cm. A partir d'une solution concentrée (e.g. à 10 M), est alors ajouté le volume d'une solution d'acide, par exemple d'acide chlorhydrique, correspondant à un mélange préférentiellement équimolaire de protons $H^+$ et d'ions disulfite $S_2O_5^{2-}$. Il peut se former des colloïdes de sélénium. La solution devient trouble immédiatement et prend une couleur typique rouge-bordeau. Après un certain temps de dépôt, les substrats sont sortis de la solution, rincés à l'eau déionisée et séchés à l'argon. Si la solution est maintenue entre 50 et 70°C pendant le dépôt de sélénium, les dépôts obtenus sont noirs (forme cristalline hexagonale du Se). Si le dépôt est réalisé à température ambiante, les dépôts obtenus sont rouge orange (rouge : forme amorphe de Se orange : forme cristalline monoclinique $\alpha$ ou $\beta$).

Les dépôts sont homogènes et couvrants. L'épaisseur des dépôts de sélénium obtenus, pouvant aller jusqu'à quelques $\mu$m, dépend du temps de dépôt durant lequel les substrats ont été laissés dans la solution et de la concentration initiale de la solution mère. Les temps de dépôts typiques varient entre 1 minute et 60 minutes, selon le degré de sélénisation désiré, pendant le recuit.

Le sélénium resté en solution se dépose au fond du bécher et peut être recyclé pour un dépôt suivant. Il n'y a donc pas de perte de sélénium pendant le dépôt de sélénium par dépôt chimique en solution.

La couche mince riche en sélénium est avantageusement déposée entre le précurseur et la couche de soufre, pour limiter l'exodiffusion du sélénium lors de l'étape de recuit b).

L'apport d'une couche mince supplémentaire riche en sélénium permet également de contrôler la largeur de bande interdite en fonction de l'épaisseur et de la proportion relative de la couche de sélénium.

Ainsi, on peut réaliser des couches minces déposées sur la couche mince de précurseur CIGS et présentant en alternance des couches incluant du soufre et du sélénium, toutes obtenues par exemple par CBD. On peut même envisager de réaliser simultanément le dépôt d'une couche mixte contenant du sélénium et du soufre, à partir d'un bain contenant à la fois du sélénium et du soufre, dans des proportions contrôlées. L'étape de recuit permet ensuite la diffusion du soufre et du sélénium au sein de la couche mince de précurseur. Ce recuit dans le cas de couches minces incluant du soufre et du sélénium doit être effectué pendant des durées inférieures ou de l'ordre de quelques dizaines de secondes, durées suffisamment courtes pour obtenir sensiblement la diffusion de l'intégralité du soufre et du sélénium vers la couche de CIGS.

Que l'on effectue le dépôt par CBD d'une couche mince incluant du soufre, du sélénium, ou un mélange des deux, le bain chimique peut contenir une suspension colloïdale respectivement de soufre, de sélénium ou d'un mélange soufre/sélénium dans un solvant. Bien entendu, les proportions de soufre et de sélénium dans le bain de colloïdes sont déterminées en fonction de la largeur de bande interdite souhaitée.

Pour le dépôt d'une telle couche (de soufre, de sélénium, ou d'un mélange des deux), le bain chimique peut alternativement se présenter sous la forme d'une solution contenant respectivement du soufre, du sélénium ou un mélange soufre/sélénium dissous dans un solvant. Bien entendu, les proportions de soufre et de sélénium dans le bain sont déterminées en fonction de la largeur de bande interdite souhaitée.

Les couches superficielles contenant au moins du soufre présentent par ailleurs l'avantage lors du recuit de constituer une couche protectrice limitant l'évaporation d'éléments volatils du précurseur comme le sélénium.

D'une manière générale, le procédé selon l'invention permet avantageusement de limiter l'exodiffusion du sélénium de la couche de précurseur, et favorise la diffusion du soufre vers cette dernière. Le procédé permet avantageusement d'obtenir une composition finale dans des rapports stoechiométriques désirés.

**Revendications**

1. Procédé de fabrication en couches minces d'alliages semi-conducteurs de type I-III-VI$_2$ incluant du soufre, pour des applications photovoltaïques, dans lequel :

    a) on dépose sur un substrat une hétérostructure comprenant une couche mince de précurseur I-III-VI$_2$ sensiblement amorphe, et une couche mince incluant au moins du soufre élémentaire,
    la couche de précurseur étant déposée tout en mélangeant des éléments constitutifs du précurseur de manière à conférer au précurseur une structure comportant des grains nanométriques d'alliages, joints par des phases amorphes, et
    le dépôt de la couche mince incluant du soufre étant réalisé par dépôt chimique en solution,

le substrat et la couche de précurseur étant placés dans un réacteur dans lequel est versée une solution contenant des ions thiosulfate $S_2O_3^{2-}$,

b) on recuit l'hétérostructure pour favoriser, à la fois :

- la diffusion du soufre dans la couche de précurseur,
- la cristallisation au moins partielle de l'alliage I-III-VI$_2$ de ladite couche de précurseur avec une stoechiométrie incluant ainsi du soufre.

**2.** Procédé selon la revendication 1, dans laquel on dépose par électrolyse la couche de précurseur.

**3.** Procédé selon la revendication 1 ou 2, dans lequel on prévoit un pré-recuit partiel supplémentaire entre les étapes a) et b) afin d'amorcer une cristallisation partielle de la couche mince de précurseur.

**4.** Procédé selon l'une des revendications précédentes, dans lequel la couche mince incluant du soufre présente une interface commune avec la couche de précurseur.

**5.** Procédé selon la revendication 4, dans lequel la couche mince incluant du soufre est déposée directement sur la couche de précurseur.

**6.** Procédé selon l'une des revendications précédentes, dans lequel le recuit de l'hétérostructure est effectué pendant des durées inférieures ou de l'ordre de quelques dizaines de secondes, et à une puissance de l'ordre de quelques W/cm$^2$.

**7.** Procédé selon la revendication précédente, dans lequel une température de l'hétérostructure est élevée à plus de 450° C à l'étape b).

**8.** Procédé selon la revendication précédente, dans lequel une puissance transférée à l'hétérostructure est supérieure à 5 W/cm$^2$.

**9.** Procédé selon la revendication précédente, dans lequel la puissance transférée à la couche est supérieure à 10 W/cm$^2$, pendant une durée inférieure à 30 secondes.

**10.** Procédé selon la revendication précédente, dans lequel à l'étape a), on verse un volume d'acide correspondant à un mélange, de préférence équimolaire, de protons H$^+$ et d'ions thiosulfate $S_2O_3^{2-}$.

**11.** Procédé selon la revendication précédente, dans lequel la couche incluant du soufre est sensiblement homogène en épaisseur dans une fourchette de 5% sur une surface de 30x30 cm$^2$.

**12.** Procédé selon l'une des revendications précédentes, dans lequel à l'étape a) on dépose également au moins une couche mince supplémentaire riche en sélénium.

**13.** Procédé selon la revendication précédente, dans lequel la couche mince supplémentaire riche en sélénium est déposée entre le précurseur et la couche de soufre, pour limiter l'exodiffusion du sélénium.

**14.** Procédé selon la revendication précédente, dans lequel la couche mince supplémentaire riche en sélénium est réalisée par dépôt chimique en solution.

**15.** Procédé selon la revendication précédente, dans lequel la couche mince supplémentaire riche en sélénium est préparée à partir d'une solution de disulfite à laquelle est ajoutée un additif lui conférant un pH basique.

**16.** Procédé selon la revendication 12
dans lequel le dépôt chimique est effectué dans un bain contenant à la fois du sélénium et du soufre permettant le dépôt d'une couche constituée par un mélange de soufre et de sélénium dans des proportions contrôlées.

**17.** Procédé selon l'une des revendications 12 à 16,
dans lequel le bain chimique est une suspension colloïdale de soufre, de sélénium ou d'un mélange soufre /sélénium dans un solvant.

**18.** Procédé selon l'une des revendications 12 à 16,
dans lequel le bain chimique est une solution de soufre, de sélénium ou d'un mélange soufre / sélénium dissous dans un solvant.

**19.** Procédé selon l'une des revendications précédentes, dans lequel une proportion de soufre dans l'alliage I-III-VI$_2$ obtenu à l'étape b), et une largeur de bande interdite, sont contrôlées au moins en fonction d'une épaisseur relative de la couche incluant du soufre.

**20.** Procédé selon l'une des revendications 12 à 15, dans lequel des proportions respectives de soufre et de sélénium dans l'alliage obtenu à l'étape b), et d'une largeur de bande interdite, sont contrôlées en fonction des épaisseurs respectives des couches de soufre et de sélénium.

**Claims**

**1.** A process for fabricating thin films of semiconductor alloys of the I-III-VI$_2$ type that includes sulfur, for photovoltaic applications, in which:

a) a heterostructure comprising a thin film of substantially amorphous I-III-VI$_2$ precursor and a thin film including at least elemental sulfur, is deposited on a substrate,
the thin film of precursor being deposited while mixing the constituent elements of the precursor so as to give the precursor a structure comprising nanograins of alloys joined together by amorphous phases; and
the deposition of the thin film including sulfur is carried out by chemical bath deposition,
the substrate and the precursor film being deposited in a reactor into which a solution containing thiosulfate ions S$_2$O$_3{}^2$ is poured,
b) the heterostructure is annealed in order to favor both:

- diffusion of the sulfur into the precursor film and
- at least partial crystallization of the I-III-VI$_2$ alloy of the said precursor film with a stoichiometry thus including sulfur.

**2.** The process as claimed in claim 1, in which the thin film of precursor is deposited by electrolysis.

**3.** The process as claimed in claim 1 or 2, in which an additional partial pre-annealing step is provided between steps a) and b) so as to initiate partial crystallization of the thin film of precursor.

**4.** The process as claimed in one of the preceding claims, in which the thin film including sulfur has a common interface with the precursor film.

**5.** The process as claimed in claim 4, in which the thin film including sulfur is deposited directly on the precursor film.

**6.** The process as claimed in one of the preceding claims, in which the heterostructure is annealed for durations of the order of a few tens of seconds or less and with a power of the order of a few W/cm$^2$.

**7.** The process as claimed in the preceding claim, in which the temperature of the heterostructure is raised to 450°C in step b).

**8.** The process as claimed in the preceding claim, in which the power transferred to the heterostructure is greater than 5 W/cm$^2$.

**9.** The process as claimed in the preceding claim, in which the power transferred to the film is greater than 10 W/cm$^2$ over a duration of less than 30 seconds.

**10.** The process as claimed in the preceding claim, in which, in step a), a volume of acid corresponding to a mixture, preferably equimolar mixture, of protons H$^+$ and thiosulfate ions S$_2$O$_3{}^2$ is poured in.

**11.** The process as claimed in the preceding claim, in which the film including sulfur is substantially homogeneous thickness-wise within a 5% range over an area measuring 30 $\times$ 30 cm$^2$.

**12.** The process as claimed in one of the preceding claims, in which, in step a), at least one selenium-rich additional thin film is also deposited.

**13.** The process as claimed in the preceding claim, in which the selenium-rich additional thin film is deposited between the precursor and the sulfur film, in order to limit exodiffusion of the selenium.

**14.** The process as claimed in the preceding claim, in which the selenium-rich additional thin film is produced by chemical bath deposition.

**15.** The process as claimed in the preceding claim, in which the selenium-rich additional thin film is prepared from a disulfite solution to which an additive giving it a basic pH is added.

**16.** The process as claimed in claim 12, in which the chemical deposition is carried out in a bath containing both selenium and sulfur, allowing a film consisting of a mixture of sulfur and selenium to be deposited in controlled proportions.

**17.** The process as claimed in one of claims 12 to 16, in which the chemical bath is a colloidal suspension of sulfur, selenium or a sulfur/selenium mixture in a solvent.

**18.** The process as claimed in one of claims 12 to 16, in which the chemical bath is a solution of sulfur, selenium or a sulfur/selenium mixture dissolved in a solvent.

**19.** The process as claimed in one of the preceding claims, in which a proportion of sulfur in the alloy obtained in step b) and consequently the bandgap width are controlled at least according to the relative thickness of the film including sulfur.

**20.** The process as claimed in one of claims 12 to 15, in which respective proportions of sulfur and selenium in the alloy obtained in step b) and consequently the bandgap width are controlled according to the respective thicknesses of the sulfur and selenium films.

**Patentansprüche**

**1.** Verfahren zur Herstellung von Dünnschichten aus Schwefel-enthaltenden Halbleiterlegierungen vom Typ I-III-VI$_2$ für Photovoltaik-Anwendungen, wobei:

a) eine Heterostruktur, die eine Dünnschicht aus im Wesentlichen amorphem I-III-VI$_2$-Vorläufer und eine mindestens Elementarschwefel enthaltende Dünnschicht umfasst, auf einem Substrat abgeschieden wird, wobei die Vorläuferschicht abgeschieden wird, indem Bestandteile des Vorläufers gemischt werden, um dem Vorläufer eine Struktur zu verleihen, die Nanokörner der Legierungen umfasst, die durch amorphe Phasen verbunden sind, und wobei das Abscheiden der Schwefel-enthaltenden Dünnschicht durch chemisches Badabscheiden in Lösung durchgeführt wird, wobei das Substrat und die Vorläuferschicht in einem Reaktor angeordnet werden, in den eine Lösung, die Thiosulfationen S$_2$O$_3$$^{2-}$ enthält, eingegossen wird, b) die Heterostruktur ausgeheizt wird, um gleichzeitig:

- die Diffusion des Schwefels in der Vorläuferschicht,
- die mindestens teilweise Kristallisation der I-III-VI$_2$-Legierung der Vorläuferschicht mit einer Stöchiometrie, die so Schwefel enthält, zu befördern.

**2.** Verfahren nach Anspruch 1, wobei die Vorläuferschicht durch Elektrolyse abgeschieden wird.

**3.** Verfahren nach Anspruch 1 oder 2, wobei ein zusätzliches teilweises Vorausheizen zwischen den Schritten a) und b) bereitgestellt wird, um eine teilweise Kristallisation der Vorläuferdünnschicht zu initiieren.

**4.** Verfahren nach einem der vorhergehenden Ansprüche, wobei die Schwefel-enthaltende Dünnschicht eine gemeinsame Schnittstelle mit der Vorläuferschicht aufweist.

**5.** Verfahren nach Anspruch 4, wobei die Schwefel-enthaltende Dünnschicht direkt auf der Vorläuferschicht abgeschieden wird.

**6.** Verfahren nach einem der vorhergehenden Ansprüche, wobei das Glühen der Heterostruktur für eine Dauer von weniger als oder im Bereich von einigen zehn Sekunden und bei einer Leistung im Bereich von einigen $W/cm^2$ durchgeführt wird.

**7.** Verfahren nach dem vorhergehenden Anspruch, wobei in Schritt b) eine Temperatur der Heterostruktur auf mehr als 450 °C erhöht wird.

**8.** Verfahren nach dem vorhergehenden Anspruch, wobei die auf die Heterostruktur übertragene Leistung größer als 5 $W/cm^2$ ist.

**9.** Verfahren nach dem vorhergehenden Anspruch, wobei die auf die Schicht übertragene Leistung über einen Zeitraum von weniger als 30 Sekunden größer als 10 $W/cm^2$ ist.

**10.** Verfahren nach einem der vorhergehenden Ansprüche, wobei in Schritt a) ein Säurevolumen, das einem Gemisch, bevorzugt einem äquimolaren Gemisch aus den Protonen $H^+$ und den Thiosulfationen $S_2O_3^{2-}$ entspricht, eingegossen wird.

**11.** Verfahren nach dem vorhergehenden Anspruch, wobei die Schwefel-enthaltende Schicht bezüglich der Dicke auf einer Fläche von 30x30 $cm^2$ innerhalb einer Bandbreite von 5 % im Wesentlichen homogen ist.

**12.** Verfahren nach einem der vorhergehenden Ansprüche, wobei in Schritt a) außerdem mindestens eine zusätzliche seleniumreiche Dünnschicht abgeschieden wird.

**13.** Verfahren nach dem vorhergehenden Anspruch, wobei die zusätzliche seleniumreiche Dünnschicht zwischen dem Vorläufer und der Schwefelschicht abgeschieden wird, um die Exodiffusion des Seleniums zu begrenzen.

**14.** Verfahren nach dem vorhergehenden Anspruch, wobei die zusätzliche seleniumreiche Dünnschicht durch chemisches Badabscheiden realisiert wird.

**15.** Verfahren nach dem vorhergehenden Anspruch, wobei die zusätzliche seleniumreiche Dünnschicht aus einer Disulfitlösung hergestellt wird, der ein Additiv zugegeben wird, das ihr einen basischen pH-Wert verleiht.

**16.** Verfahren nach Anspruch 12, wobei die chemische Abscheidung in einem Bad durchgeführt wird, das gleichzeitig Selenium und Schwefel enthält, wobei das Abscheiden einer Schicht, die aus einem Gemisch aus Schwefel und Selenium in kontrollierten Anteilen bestehend, ermöglicht wird.

**17.** Verfahren nach einem der Ansprüche 12 bis 16, wobei das chemische Bad eine kolloidale Suspension aus Schwefel oder einem Schwefel-/Selenium-Gemisch in einem Lösemittel ist.

**18.** Verfahren nach einem der Ansprüche 12 bis 16, wobei das chemische Bad eine Lösung aus Schwefel oder Selenium oder einem Schwefel-/Selenium-Gemisch, aufgelöst in einem Lösemittel, ist.

**19.** Verfahren nach einem der vorhergehenden Ansprüche, wobei der Schwefelanteil in der in Schritt b) erhaltenen I-III-VI$_2$-Legierung und der Bandabstand mindestens in Abhängigkeit von einer relativen Dicke der Schwefel-enthaltenden Schicht kontrolliert werden.

**20.** Verfahren nach einem der Ansprüche 12 bis 15, wobei die jeweiligen Schwefel- und Seleniumanteile in der in Schritt b) erhaltenen Legierung und der Bandabstand in Abhängigkeit von den jeweiligen Dicken der Schwefel- und Seleniumschichten kontrolliert werden.

FIG.1.

10
20
30
40

An    REF    Ca

(+)                              (−)

B

M

FIG.2.

PH

GR

FIG.3.

FIG.4.

FIG.5.

FIG.6.2

FIG.6.1

FIG.7.

FIG.8.

FIG.9.

FIG.10.1

FIG.10.2

## EP 1 883 975 B1

### RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03094246 A
- US 5730852 A
- US 5578503 A
- WO 03094246 A1
- WO 0137324 A1
- FR 2849450 A1
- FR 2849532 A1

**Littérature non-brevet citée dans la description**

- **V. ALBERTS ; F. D. DEJENE.** *Journal of Physics D : Appl. Phys.,* 2002, vol. 35, 2021-2025
- **K. SIEMER ; J. KLAER ; I. LUCK ; J. BRUNS ; R. KLENK ; D. BRAÜNIG.** *Solar Energy Materials and Solar Cells,* 2001, vol. 67, 159-166
- **NADENAU et al.** Solar cells based on CuInSe2 and related compounds: material and device properties and processing. *Progress in Photovoltaics : Research and applications,* 1995, vol. 3 (6), 363-382